# EUROPÄISCHE PATENTSCHRIFT

(11) **EP 0 891 646 B1**
(45) Veröffentlichungstag und Bekanntmachung des Hinweises auf die Patenterteilung: **04.07.2001**
(21) Anmeldenummer: 98910578.8
(22) Anmeldetag: 16.01.1998
(51) Int. Cl.: H01R 35/02

(54) **SIGNALLEITER**
SIGNAL CONDUCTOR
CIRCUIT DE SIGNAUX

(30) Priorität: 17.01.1997 DE 19701510
(43) Veröffentlichungstag der Anmeldung: 20.01.1999
(73) Patentinhaber: Stemmann-Technik GmbH, 48465 Schüttorf (DE)
(72) Erfinder: BARTHELT, Klaus, D-53501 Grafschaft 1 (DE)
(74) Vertreter: Bockermann, Rolf, Dipl.-Ing.
(86) Internationale Anmeldenummer: DE9800137
(87) Internationale Veröffentlichungsnummer: WO9832193

(56) Entgegenhaltungen:
- EP-A- 0 243 047
- EP-A- 0 444 584
- EP-A- 0 495 507
- EP-A- 0 520 245
- US-A- 5 556 300

## Beschreibung

Die Erfindung betrifft einen Signalleiter für hochfrequente Signale gemäß den Merkmalen im Oberbegriff des Patentanspruchs.

Hochfrequenztechnisch ist es sehr problematisch, mehrere Koaxialkabel mit den Schleifringen eines Schleifringkörpers zu verbinden. Grund hierfür bildet der Sachverhalt, dass an den Koaxialkabeln auf längeren Abschnitten sorgfältig die Schirme entfernt werden müssen, damit sowohl die Innenleiter als auch die Schirme mit den Schleifringen kontaktiert werden können. In Anbetracht der Tatsache dass die Koaxialkabel meistens einen großen Durchmesser aufweisen, ist auch die Anzahl der unterbringbaren Koaxialkabel zwangsläufig begrenzt. Hinzu kommt, dass die Praxis bemüht ist, den Durchmesser der Schleifringe so klein wie nur möglich zu halten, da bei zunehmendem Durchmesser der Durchmesser des Gesamtgehäuses logarithmisch ansteigt.

Die Trennung des Schirms eines Koaxialkabels vom Dielektrikum erzeugt immer eine Unstetigkeitsstelle und demzufolge Reflexionen sowie Störsignale. Eine unstetige Stelle erhöht aber die Durchgangsdämpfung, wodurch die Qualität einer Signalübertragung stark negativ beeinflusst wird.

Eine weitere Eigenschaft bekannter Hochfrequenz-Schleifringkörper ist die aufwendige Kontaktierung. Sie wurden daher nur als Verbundkörper hergestellt, das heißt, die Schleifringe wurden zusammen mit den Koaxialkabeln in Gießharze eingebettet. Derartige Gießharze weisen indessen sehr hohe dielektrische Werte auf mit einer ungünstigen Folge hinsichtlich der geometrischen Abmessungen der Schleifringkörper. Diese wurden einfach zu groß.

Im Umfang der US 5,556,300 ist ein Signalleiter unter anderem auch für hochfrequente Signale bekannt, der als flaches flexibles Kabel ausgebildet ist. An einem Ende weist dieses Kabel eine flexible und flache Leiterabschirmung auf. Eine flexible Gummiisolierung trennt die Leiterabschirmung von einem flexiblen Mehrfachsignalleiter, welcher sich in der Gummiisolierung erstreckt. Mindestens ein flexibler Masseleiter verläuft zwischen der Gummiisolierung und der Leiterabschirmung. Der Mehrfachsignalleiter und jeder Masseleiter stehen stirnseitig gegenüber der Gummiisolierung vor und sind auf einer Versteifung aufgebracht. Sie können als elektrischer Stecker in einer entsprechend gestalteten Hülse aufgenommen werden. Ein solcher Signalleiter ist prinzipiell mit den Nachteilen behaftet, wie sie voraufgehend geschildert worden sind.

Der Erfindung liegt ausgehend vom Stand der Technik die Aufgabe zugrunde, einen Signalleiter für hochfrequente Signale zur Verbindung mit den Schleifringen eines Schleifringkörpers zu schaffen, der nicht nur einfach aufgebaut ist und einen geringen Einbauraum verlangt, sondern bei dem auch Abisolierungen entfallen und keine Lötstellen dünner Drähte mehr erforderlich sind.

Die Lösung dieser Aufgabe besteht nach der Erfindung in den kennzeichnenden Merkmalen des Patentanspruchs.

Die grundlegende Bauart gemäß der Erfindung sieht eine elektrisch leitende Signalbahn zwischen zwei elektrisch leitenden Massebahnen vor. Die Signalbahn und die Massebahnen bestehen vorzugsweise aus Kupfer. Um eine gewünschte Impedanz zu erreichen, wird zwischen der Signalbahn und den parallel benachbarten Massebahnen ein Abstand vorgesehen, der seinerseits vom Dielektrikum abhängig ist. Folglich werden auch die geometrischen Abmessungen des Signalleiters durch das Dielektrikum bestimmt. Indessen bildet es jetzt kein Problem mehr und es ist lediglich vom verfügbaren Raum innerhalb eines Schleifringkörpers abhängig, mehrere Signalbahnen und Massebahnen nebeneinander vorzusehen, wobei jedoch jede Signalbahn immer zwischen zwei Massebahnen liegen muss.

Unabhängig von der Anzahl solcher Bahnkonfigurationen werden diese jetzt zwischen einer 1. und einer 2. Trägerschicht mit auf die gewünschte Impedanz abgestimmter geeigneter Dielektrizität angeordnet. Die beiden Trägerschichten können aus laminatartigen Trägerplatten gebildet sein. Dabei ist es denkbar, dass eine der beiden Trägerschichten, z.B. die 1. Trägerschicht, auf einer Seite kupferkaschiert wird, wobei die Signalbahn und die Massebahnen aus der Kupferkaschierung herausgeätzt werden. Es sind aber auch andere Formen der Ausbildung und Anordnung der Signal- und Massebahnen denkbar.

Auf der anderen Seite einer derart mit Signal- und Massebahnen versehenen 1. Trägerschicht wird dann eine 1. Abschirmung angebracht. Diese kann insbesondere aus einer Kupferschicht, z.B. einer Kupferfolie, bestehen.

Die nicht mit den Signal- und Massebahnen versehene 2. Trägerschicht wird auf der den Signal- und Massebahnen abgewandten Seite mit einer Kunststofffolie versehen, die quer abstehende Anschlussfahnen aufweist, wobei die Anzahl der Anschlussfahnen der Anzahl der Signal- und Massebahnen entspricht.

Die den Signal- und Massebahnen abgewandte Seite der Kunststofffolie wird mit einer 2. Abschirmung, z.B. einer Kupferfolie, versehen, welche allerdings im Bereich der Anschlussfahnen ausgespart ist.

Anschließend werden die Signal- und Massebahnen durch die 2. Trägerschicht und die Kunststofffolie mit elektrisch leitenden Kontaktstreifen, insbesondere aus Kupfer, kontaktiert, so dass eine elektrisch leitende Verbindung zwischen den mit den Schleifringen in Beziehung bringbaren Kontaktstreifen und den Signal- und Massebahnen besteht.

Ein derart ausgebildeter und in den Zentralbereich eines Schleifringkörpers lötfrei integrierbarer, insbesondere plattenartiger, Signalleiter hat eine Reihe von Vorteilen.

Ein Vorteil ist, dass zwei solche Signalleiter in Firm einer Mehrlagenplatte aneinander gelegt werden können. Die Kontaktstreifen stehen dann nach beiden Seiten quer zur Längserstreckung des Signalleiters vor. Durch diese Maßnahme kann die Anzahl der Kontaktierungen auf nahezu gleichem Einbauraum verdoppelt werden.

Ein weiterer Vorteil ist, dass die Kontaktstreifen beim Einbau des Signalleiters in einen Schleifringkörper lediglich zwischen die auf der Trägerwelle des Schleifringkörpers gestapelten Schleifringe und Isolierringe geklemmt werden können. Eine Lötverbindung entfällt.

Da im Rahmen der Erfindung die Abstände zwischen den parallel zueinander verlaufenden Signal- und Massebahnen über ihre gesamte Länge exakt gleich gehalten werden können, ist es vorteilhaft möglich, die Impedanz über diese gesamte Länge, z.B. zwischen einem Stecker und dem zugehörigen Schleifring, absolut und reproduzierbar einzuhalten. Die Reproduzierbarkeit ist insbesondere deshalb gegeben, weil durch die Konfiguration des Signalleiters und der dadurch bestimmten Fertigung der Aufbau stets identisch eingehalten werden kann.

Ein weiterer besonderer Vorteil ist mit der Erfindung dadurch verbunden, dass jetzt solche Isolierringe zwischen den Schleifringen verwendet werden können, deren Materialien nur geringe dielektrische Werte aufweisen. Die Verwendung von Materialien mit geringen dielektrischen Werten verringert somit deutlich den Einbauraum, was dem hier in Rede stehenden Hochfrequenzsystem außerordentlich vorteilhaft entgegenkommt und sein Anwendungsspektrum vervielfacht.

Der Einsatz eines erfindungsgemäßen Signalleiters mit der speziellen Durchkontaktierung zwischen den Signal- und Massebahnen und den Kontaktstreifen schafft grundsätzlich reproduzierbare Verhältnisse. Sie lässt auch ein Stapeln zu. Hierdurch werden Reparaturen ermöglicht und Montagen beschleunigt, da zeitaufwendige Arbeitsschritte, wie z.B. ein Abisolieren und ein Anlöten meist sehr dünner Drähte entfallen.

Insgesamt ist festzustellen, dass jetzt nicht nur sowohl im Durchmesser als auch in der Länge sehr kompakte Schleifringkörper mit einer Vielzahl von Schleifringen bereitgestellt werden können, sondern dass mangels Unstetigkeitsstellen - weil keine Abschirmungen entfernt werden müssen - die Durchgangsdämpfung extrem niedrig gehalten werden kann und somit die Qualität der Übertragung hochfrequenter Signale außerordentlich positiv beeinflusst wird.

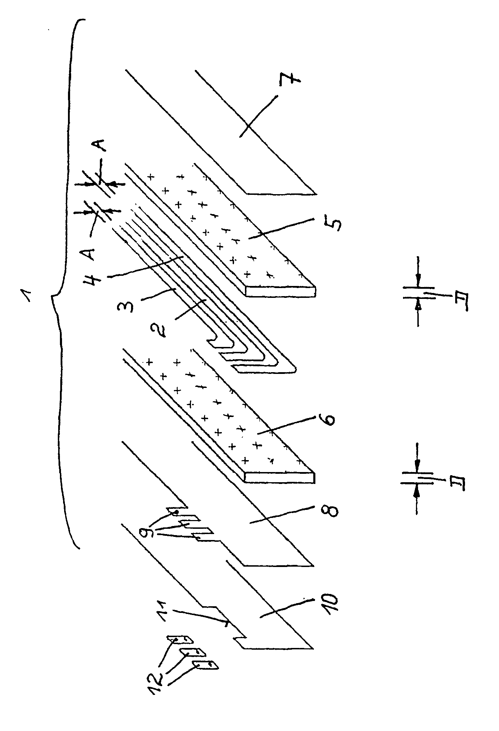

Die Erfindung ist nachfolgend anhand eines in der Zeichnung dargestellten Ausführungsbeispiels näher erläutert.

Mit 1 ist in Explosivdarstellung ein Längenabschnitt eines plattenartigen Signalleiters für hochfrequente Signale zur Verbindung mit drei Schleifringen eines nicht näher veranschaulichten Schleifringkörpers bezeichnet.

Der Signalleiter 1 wird axial in den Schleifringkörper eingebaut. Er weist eine elektrisch leitende L-förmige Signalbahn 2 aus Kupfer auf. Neben dieser Signalbahn 2 sind in einem vorbestimmten Abstand A zwei parallel verlaufende elektrisch leitende Massebahnen 3, 4 aus Kupfer vorgesehen. Die Signalbahn 2 und die Massebahnen 3, 4 werden zwischen einer 1. plattenartigen Trägerschicht 5 und einer 2. plattenartigen Trägerschicht 6 mit einem geeigneten Dielektrikum angeordnet. Eine Seite der 1. Trägerschicht 5 ist mit Kupfer kaschiert und die Signal- und Massebahnen 2-4 sind aus der Kupferkaschierung herausgeätzt. Das Dielektrikum der beiden Trägerschichten 5, 6 bestimmt auch den Abstand A der Signalbahn 2 von den Massebahnen 3, 4 sowie die Dicke D der beiden Trägerschichten 5, 6. Die Abstände A und die Dicke D bestimmen ihrerseits die gewünschte Impedanz.

Die 1. Trägerschicht 5 wird auf der den Signal- und Massebahnen 2-4 abgewandten Seite mit einer 1. Abschirmung 7 in Form einer Kupferfolie beschichtet.

Die den Signal- und Massebahnen 2-4 abgewandte Seite der 2. Trägerschicht 6 wird mit einer Kunststofffolie 8 mit einer der Anzahl der Signal- und Massebahnen 2-4 entsprechenden Anzahl quer abstehender Anschlussfahnen 9 versehen.

Auf der den Signal- und Massebahnen 2-4 abgewandten Seite der Kunststofffolie 8 wird eine 2. Abschirmung 10 in Form einer Kupferfolie aufgebracht, welche im Bereich der Anschlussfahnen 9 eine Aussparung 11 aufweist.

Kupferne Kontaktstreifen 12 werden dann über die Anschlussfahnen 9 der Kunststofffolie 8 mit den Signal- und Massebahnen 2-4 zwischen den beiden Trägerschichten 5, 6 kontaktiert.

Die Kontaktstreifen 12 können bei der Zuordnung des Signalleiters 1 zu einem Schleifringkörper jeweils zwischen einen Schleifring und einen Isolierring geklemmt werden. Lötverbindungen sind folglich nicht erforderlich.

Mit Hilfe des Signalleiters 1 können Signale über die Signalbahn 2 an den entsprechenden Kontaktstreifen 12 und damit an einen Schleifring gebracht werden.

## Patentansprüche

1. Signalleiter (1) für hochfrequente Signale, welcher mindestens eine elektrisch leitende Signalbahn (2) in seitlichem Abstand (A) zwischen zwei elektrisch leitenden Massebahnen (3, 4), zwei Trägerschichten (5, 6) und Abschirmungen (7, 10) neben den Trägerschichten (5, 6) aufweist,
**dadurch gekennzeichnet**, dass zur Verbindung mit wenigstens drei Schleifringen eines Schleifringkörpers auch die Massebahnen (3, 4) zwischen den Trägerschichten (5, 6) mit geeigneter Dielektrizität angeordnet sind, zwischen einer 2. Abschirmung (10) und einer 2. Trägerschicht (6) eine Anschlussfahnen (9) aufweisende Kunststofffolie (8) angeordnet ist, die 2. Abschirmung (10) im Bereich der Anschlussfahnen (9) eine Aussparung (11) aufweist und elektrisch leitende Kontaktstreifen (12) auf den der Signalbahn (2) und den Massebahnen (3, 4) abgewandten Seiten der Anschlussfahnen (9) mit der Signalbahn (2) und den Massebahnen (3, 4) verbunden sind.

## Claims

1. A conductor (1) for high-frequency signals comprising at least one electrically conducting signal track (2) in the lateral space (A) between two electrically conducting earth tracks (3, 4), two carrier layers (5, 6) and screens (7, 10) alongside the carrier layers (5, 6), characterised in that in order to connect to at least three slip rings of a slip-ring member, the earth tracks (3, 4) are also disposed with suitable dielectricity between the carrier layers (5, 6), a plastic sheet (8) bearing connecting lugs (9) is disposed between a second screen (10) and a second carrier layer (6), the second screen (10) has a recess (11) in the region of the connecting lugs (9), and electrically conducting contact strips (12) on the sides of the connecting lugs (9) remote from the signal track (2) and the earth tracks (3, 4) are connected to the signal track (2) and to the earth tracks (3, 4).

## Revendications

1. Circuit de signaux (1) destiné à des signaux haute fréquence, lequel circuit présente au moins une voie de signaux (2) conductrice électriquement en espacement latéral (A) entre deux voies de masse (3,4) conductrices électriquement, deux couches porteuses (5,6) et des blindages (7,10) à côté des couches porteuses (5,6),
**caractérisé en ce que**
pour la connexion avec au moins trois bagues collectrices d'un corps de bagues collectrices, les voies de masse (3,4) sont également disposées entre les couches porteuses (5,6) avec une diélectricité appropriée, entre un deuxième blindage (10) et une deuxième couche porteuse (6) est agencée une feuille en matière synthétique (8) présentant des barrettes de connexion (9), au niveau des barrettes de connexion (9) le deuxième blindage (10) présente un évidement (11) et des bandes de contact électriquement conductrices (12) sur les côtés des barrettes de connexion (9) opposés à la voie de signaux (2) et aux voies de masse (3,4) sont connectées avec la voie de signaux (2) et les voies de masse (3,4).
